**Europäisches Patentamt**

**European Patent Office**

**Office européen des brevets**

(19)

(11) Publication number : **0 332 176 B1**

(12) **EUROPEAN PATENT SPECIFICATION**

(45) Date of publication of patent specification :
25.10.95 Bulletin 95/43

(51) Int. Cl.⁶ : **G01R 33/38, H01F 6/00**

(21) Application number : **89104124.6**

(22) Date of filing : **08.03.89**

(54) **Magnet apparatus for use in magnetic resonance imaging system.**

(30) Priority : **08.03.88 JP 52631/88**

(43) Date of publication of application :
**13.09.89 Bulletin 89/37**

(45) Publication of the grant of the patent :
**25.10.95 Bulletin 95/43**

(84) Designated Contracting States :
**DE GB NL**

(56) References cited :
**EP-A- 0 111 218**
**EP-A- 0 251 342**
**GB-A- 2 197 487**
**GB-A- 2 215 471**

(56) References cited :
**IEEE TRANSACTIONS ON MAGNETICS, vol.
MAG-23, no. 2, March 1987, pages 603-606,
New York, US; A. ISHIYAMA et al.: "Optimal
design of superconducting magnets for
whole-body NMR imaging"
IDEM
REVIEW OF SCIENTIFIC INSTRUMENTS, vol.
56, no. 1, January 1985, pages 131-135, Wood-
bury, US; D.I. HOULT et al.: "Shimming a
superconducting nuclear-magnetic-reso-
nance imaging magnet with steel"**

(73) Proprietor : **KABUSHIKI KAISHA TOSHIBA
72, Horikawa-cho,
Saiwai-ku
Kawasaki-shi, Kanagawa-ken 210, Tokyo (JP)**

(72) Inventor : **Matsutani, Kinya c/o Patent Division
Kabushiki Kaisha Toshiba
1-1 Shibaura 1-chome
Minato-ku Tokyo 105 (JP)**

(74) Representative : **Henkel, Feiler, Hänzel &
Partner
Möhlstrasse 37
D-81675 München (DE)**

## Description

The present invention relates to a magnet apparatus for use in a magnetic resonance imaging system (MRI system) and, more particularly, to a magnet apparatus having a magnetic shield for reducing a magnetic fringe field.

An MRI apparatus is provided with a bore, and a working volume where a portion to be diagnosed of a patient is located is defined in the bore. A magnet apparatus has a main superconducting coil which is arranged to surround the bore and generates a static or main magnetic field in the working volume. A gradient magnetic field is superposed on the static magnetic field, and a high-frequency signal is applied to the portion to be diagnosed of the patient. As a result, a magnetic resonance signal generated by the portion to be diagnosed is detected, thus obtaining a tomographic image of the portion.

Magnetic fluxes of the static magnetic field leak from the bore, and a magnetic fringe field is formed outside the bore. The magnetic fringe field often magnetically adversely influences a portion around the MRI apparatus. For this reason, a magnetic shield for reducing the magnetic fringe field is provided to the magnet apparatus. Conventionally, as the magnetic shield, a yoke magnetic shield and an active magnetic shield are known.

The yoke magnetic shield comprises a cylindrical member surrounding the static magnetic field superconducting coil and formed of a ferromagnetic member. The magnetic fluxes leaking from the bore are absorbed by the magnetic shield, thus reducing the magnetic fringe field. However, when the intensity of the static magnetic field is increased, an amount of leaking magnetic fluxes is also increased. For this reason, an amount of a magnetic material of the cylindrical member must be increased in correspondence with an increase in intensity of the static magnetic field. As a result, the weight of the magnetic shield is considerably increased.

For example, when a 5,000-Gauss main superconducting coil is used, a magnetic shield formed of about 5 tons of iron can provide a 5-Gauss magnetic fringe field region of about 40 m$^2$. However, when a 15,000-Gauss main superconducting coil is used, a magnetic shield formed of about 40 tons of iron is required so as to provide a 5-Gauss magnetic fringe field region of the same area. It is impossible to install an MRI system comprising such a magnetic shield in an existing hospital.

In addition, even if the static magnetic field intensity is changed during the operation of the MRI system, an absorbing amount of the leaking magnetic fluxes by the yoke magnetic shield cannot be controlled in correspondence with a change in intensity.

On the other hand, the active magnetic shield comprises a second superconducting magnetic coil for generating a second magnetic field in a direction opposite to that of the magnetic field generated by the main superconducting coil in the working volume. Outside the bore, the intensity of the magnetic field generated by the main coil is almost equal to that of the magnetic field generated by the second coil. For this reason, leaking magnetic fluxes of these two magnetic fields cancel each other, thus reducing the magnetic fringe field. On the other hand, in the working volume, the two magnetic fields are synthesized to form a static magnetic field. A difference between the intensities of the two magnetic fields is set to provide a predetermined static magnetic field intensity.

Since the active magnetic shield does not require a ferromagnetic member, its weight is smaller than the yoke magnetic shield. In addition, a current flowing through the second coil can be adjusted so as to control a suppression amount of the leaking magnetic fluxes.

However, since a difference between the intensities of the two magnetic fields is set to be the predetermined static field intensity, the number of turns of superconducting wires of the two superconducting coils must be very large. For this purpose, a large amount of superconducting wires are required. As a result, the magnet apparatus has high manufacturing cost.

Furthermore, the second coil is arranged radially outside the main coil. For this reason, the outer diameter of the magnet apparatus is considerably increased. As a result, when the magnet apparatus is transported or when the magnet apparatus is installed, a very large transportation space and installation space are necessary. An existing hospital often does not have such a large transportation space and installation space, and a passage and installation space in the hospital must sometimes be reconstructed or additionally constructed. Therefore, it is difficult to transport and install the magnet apparatus.

In a building such as a hospital, magnetic members such as reinforcements arranged in columns and floors are provided. The magnetic flux densities of the magnetic fluxes of the two magnetic fields may be changed by these magnetic members outside the bore. The magnetic fluxes whose density is changed may enter the working volume of the bore. As a result, homogeneity of the magnetic field in the working volume is deteriorated, and MRI diagnosis is disturbed.

Prior art document EP-A-0 251 342 discloses a magnetic assembly as defined in the preamble of claim 1. The magnetic shield comprises four rectangular iron plates which are positioned parallel with an axis of the bore.

EP 0 332 176 B1

Further, prior art document „Review of Scientific Instruments", vol. 56, no. 1, 1985, pages 131 to 135, discloses a magnetic apparatus for use in a NMR system, wherein pieces of ferromagnetic steal are provided for shimming a main field, and prior art document EP-A-0 111 218 describes a magnet apparatus which has a cylindrical ferromagnetic yoke magnetic field and uses ring-shaped ferromagnetic plates which are attached to the end portions of a ferromagnetic yoke magnetic shield.

It is an object of the present invention to provide a magnetic apparatus for use in a magnetic resonance imaging system, which can be small in size and in weight so that the magnet apparatus can be easily carried and installed in an existing hospital or the like, has reduced manufacturing costs, and is free from the magnetic influence from magnetic members of an installation facility. It is a further object of the present invention to provide a magnet apparatus for use in a magnetic resonance imaging system, which can maintain a magnetic field at a high homogeneity in a working volume in a bore, and can reduce a magnetic fringe field.

To solve this object the present invention provides a magnet apparatus as specified in claim 1.

A magnetic fringe field can be reduced by cooperation of an active magnetic shield and a yoke magnetic shield, and the synthesized magnetic field in the working volume is maintained at a high homogeneity. For this reason, the volumes of the active and yoke magnetic shields can be reduced to be smaller than those of the conventional shields.

As a result, the magnet apparatus can be rendered compact and light in weight. Thus, the magnet apparatus can be easily carried and installed in an existing hospital or the like.

Furthermore, an amount of use of a superconducting wire can be reduced, and the manufacturing cost of the magnet apparatus can be reduced.

A magnetic fringe field is absorbed by the yoke magnetic shield. For this reason, a magnetic fringe field reaching ferromagnetic members such as reinforcements arranged in columns and floors can be eliminated. Thus, a magnetic fringe field whose magnetic flux density is changed by these ferromagnetic members enters the working volume less often. Therefore, homogeneity of the magnetic field in the working volume can be prevented from being deteriorated by the influence of the ferromagnetic members such as reinforcements arranged in columns and floors.

This invention can be more fully understood from the following detailed description when taken in conjunction with the accompanying drawings, in which:

Fig. 1 is a perspective view and a block diagram of an MRI system;

Fig. 2 is a partially cutaway perspective view of a magnet apparatus;

Fig. 3 is a horizontal sectional view of the magnet apparatus shown in Fig. 2;

Fig. 4 is a horizontal sectional view of a magnet apparatus according to an embodiment of the present invention; and

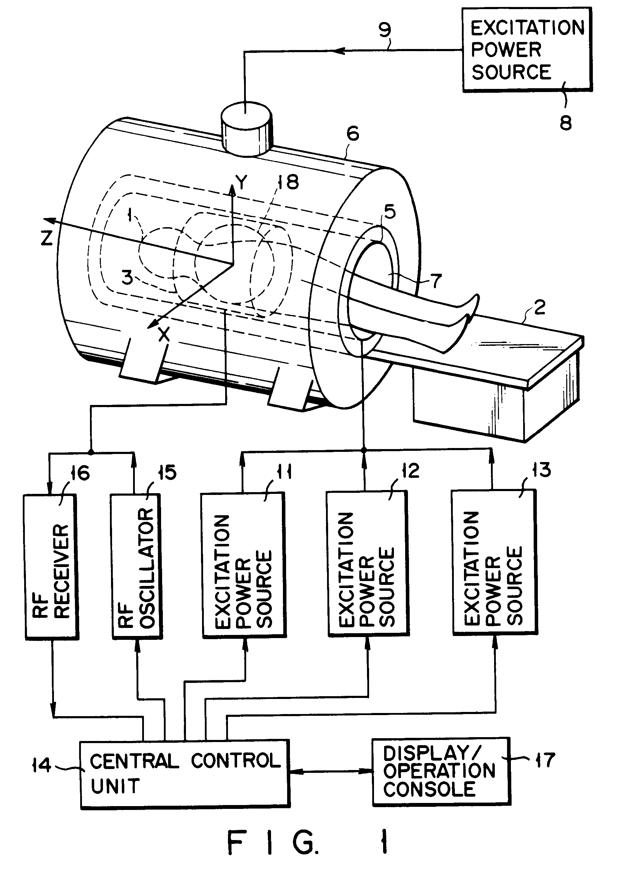

Fig. 1 shows a magnetic resonance imaging system (MRI system) in which a magnet apparatus is used.

A patient 1 lying on a couch 2 is housed in a warm bore 7. A portion to be diagnosed of the patient 1 is located in a working volume 18. A magnet apparatus 6 generates a static or main magnetic field in the working volume 18 along a Z axis. The magnet apparatus 6 is connected to an excitation power source 8. X, Y, and Z gradient magnetic field coils 5 are arranged radially inside the magnet apparatus 6. These coils 5 are connected to excitation power sources 11, 12, and 13, respectively.

Furthermore, an RF coil 3 is arranged to surround the portion to be diagnosed of the patient 1. The RF coil 3 is connected to an RF transmitter 15 and an RF receiver 16. The RF transmitter 15, the RF receiver 16, and the excitation power sources 11, 12, and 13 are connected to a central control unit 14. The control unit 14 is connected to a display/operation console 17.

The magnet apparatus 6 is excited, and as a result, generates a uniform static magnetic field in the working volume. In this case, X, Y, and Z gradient magnetic fields generated by the X, Y, and Z gradient magnetic field coils 5 are superposed on the static magnetic field. At the same time, the RF transmitter 15 is driven by a pulse sequence to apply a pulse signal. Thus, a magnetic resonance signal is induced in the portion to be diagnosed of the patient. The magnetic resonance signal is detected by the RF coil 3, and is fetched in the central control unit 14 through the RF receiver 16. The central control unit 14 performs image reproduction processing to obtain image data. The image data is converted to a video signal, and a tomographic image is displayed on the display/operation console 17.

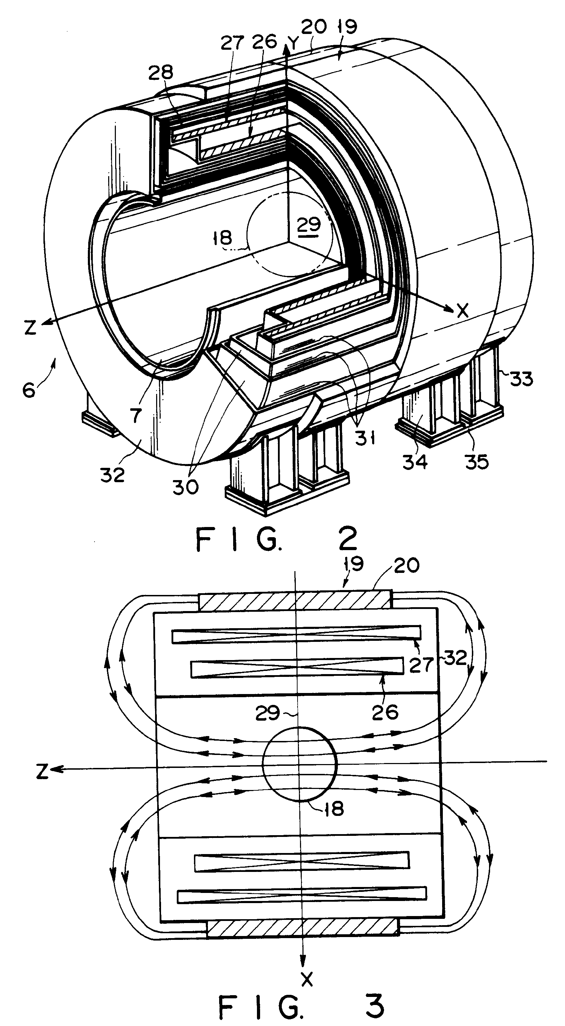

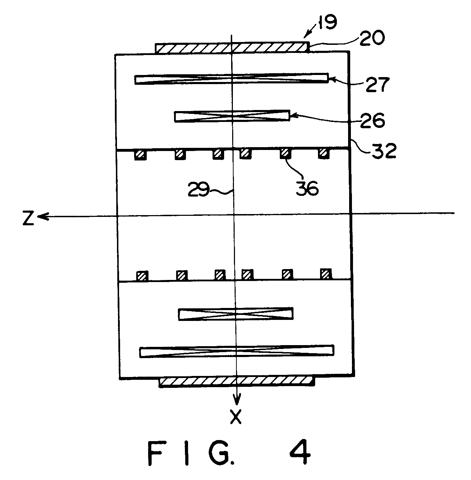

The magnet apparatus 6 will be described below with reference to Figs. 2 and 3.

The magnet apparatus 6 comprises a first superconducting coil assembly 26 for generating a first magnetic field constituting most part of the static magnetic field, a cooling means for cooling the superconducting coil, and a means for reducing a magnetic field leaking outside the magnet apparatus 6.

The first superconducting coil assembly 26 surrounds the warm bore 7, and extends along the Z axis. A mid-plane 29 (X-Y plane) of the magnet apparatus 6 is defined to be perpendicular to the Z axis. The first superconducting coil assembly 26 includes a plurality of coaxial coils symmetrically arranged with reference to

3

the mid-plane 29.

The cooling means is constituted by a liquid helium tank 28 filled with a liquid helium and housing the superconducting coil assembly 26, a plurality of heat radiation shield plates 30 covering the liquid helium tank 28, multilayered heat insulating members 31 housed between the adjacent heat radiation shield plates 30, and a vacuum container 32 which covers the heat radiation shield plates 30 and the interior of which is kept in a vacuum state. The vacuum chamber 32 is supported on legs 33. The cooling means keeps the first superconducting coil assembly 26 at a cryogenic state of 4.2 K.

It is a characteristic feature that the means for eliminating the magnetic fringe field comprises an active magnetic shield 27 and a yoke (passive) magnetic shield 19.

The active magnetic shield 27 comprises a second superconducting coil assembly which is coaxially arranged radially outside the first coil assembly 26. The second superconducting coil assembly includes a plurality of coaxial coils which are symmetrically arranged with reference to the mid-plane 29. Furthermore, the second superconducting coil assembly is housed in the liquid helium tank 28 and is cooled to 4.2 K. The second superconducting coil assembly is connected in series with the first superconducting coil assembly 26, and generates a second magnetic field in a direction opposite to that of the first magnetic field in the working volume 18.

The yoke magnetic shield 19 comprises a cylindrical shell member 20 formed of a ferromagnetic material such as iron and attached on the outer periphery of the vacuum chamber 32, and legs 34 supporting the shell member 20 and coupled to the legs 33 through coupling plates 35. The shell member 20 is arranged concentrically with the first and second superconducting coil assemblies about the Z axis. Furthermore, the shell member 20 is divided into two segments with reference to the mid-plane 29 (X-Y plane). Each of these segments is further divided into two pieces with reference a vertical plane (Y-Z plane) along the Z axis. More specifically, the shell member 20 is divided into four pieces. The length of the shell member 20 along the Z axis is shorter than that of the second superconducting coil assembly.

As shown in Fig. 3, the direction of the first magnetic field is opposite to that of the second magnetic field. For this reason, the magnetic fluxes of the first magnetic field leaking from the bore 7 and those of the second magnetic field leaking therefrom cancel each other to be weakened. The weakened magnetic fluxes are absorbed in the yoke magnetic shield 19. Thus, the leaking magnetic field is reduced.

The yoke magnetic shield electromagnetically forms a third magnetic field in the working volume 18. More specifically, some of the leaking magnetic fluxes of the first and second magnetic fields are magnetically changed by the yoke magnetic shield and enter the working volume 18 to form the third magnetic field. For this reason, the first to third magnetic fields are present in the working volume 18, and form a synthesized magnetic field.

In the MRI system, the magnetic field in the working volume 18 is required to have a high homogeneity, e.g., homogeneity of 20 ppm or less. Therefore, the synthesized magnetic field of the first to third magnetic fields in the working volume 18 is required to have a high homogeneity. For this purpose, the following means for setting the synthesized magnetic field at a high homogeneity is arranged.

The intensity of the first magnetic field generated by the first superconducting coil assembly is expressed by a component of a term of degree 0 (degree-0 term component) and components of terms of higher degrees (higher-degree term components, i.e., error components), and is series-developed as follows:

$$B_M = B_{0M} + \sum_{i=1}^{\infty} b_{iM}$$

$$= B_{0M} + b_{1M} + b_{2M} + \ldots + b_{iM} + \ldots$$

$$\ldots (1)$$

$B_M$: first magnetic field intensity

$B_{0M}$: degree-0 term component

$\sum_{i=1}^{\infty} b_{iM}$: higher-degree term components

$b_{iM}$: term of degree $i$ of the higher-degree term components

The intensity of the second magnetic field generated by the active magnetic shield is expressed by a degree-0 term component and higher-degree term components, and is series-developed as follows:

$$B_A = B_{0A} + \sum_{i=1}^{\infty} b_{iA}$$
$$= B_{0A} + b_{1A} + b_{2A} + \ldots + b_{iA} + \ldots$$
$$\ldots (2)$$

$B_A$: first magnetic field intensity

$B_{0A}$: degree-0 term component

$\sum_{i=1}^{\infty} b_{iA}$: higher-degree term components

$b_{iA}$: term of degree i of the higher-degree term components

The intensity of the third magnetic field generated by the yoke magnetic shield is expressed by a degree-0 term component and higher-degree term components, and is series-developed as follows:

$$B_Y = B_{0Y} + \sum_{i=1}^{\infty} b_{iY}$$
$$= B_{0Y} + b_{1Y} + b_{2Y} + \ldots + b_{iY} + \ldots$$
$$\ldots (3)$$

$B_Y$: first magnetic field intensity

$B_{0Y}$: degree-0 term component

$\sum_{i=1}^{\infty} b_{iY}$: higher-degree term components

$b_{iY}$: term of degree i of the higher-degree term components

Therefore, the intensity of the synthesized magnetic field is expressed by degree-0 term components and higher-degree term components as follows:

$$B_M - B_A + B_Y = B_{0M} - B_{0A} + B_{0Y}$$
$$+ \sum_{i=1}^{\infty} (b_{iM} - b_{iA} + b_{iY})$$
$$\ldots (4)$$

If the higher-degree term components (i.e., error components)

$$\sum_{i=1}^{\infty}$$

$(b_{iM} - b_{iA} + b_{iY})$ are set to be substantially zero, the intensity of the synthesized magnetic field consists of only the degree-0 term components. Thus, the synthesized magnetic field is set at a high homogeneity.

For this purpose, the numbers of turns of the superconducting wires of the first and second superconducting coil assemblies and the amount of the ferromagnetic member of the yoke magnetic shield are determined so that the sums of the terms of the same degrees of the higher-degree term components of the first to third magnetic fields are set to be substantially zero, that is, $b_{1M} - b_{1A} + b_{1Y}$ 0, $b_{2M} - b_{2A} + b_{2Y}$ 0,..., $b_{iM} - b_{iA} + b_{iY}$ 0. As a result, the intensity of the synthesized magnetic field is defined by only the degree-0 term components $B_{0M} - B_{0A} + B_{0Y}$, and the synthesized magnetic field is set at a high homogeneity.

The means for setting the higher-degree term components of the synthesized magnetic fields to be substantially zero may be arranged as follows.

The number of turns of the superconducting wire of the first superconducting coil assembly is set, so that the terms of the higher-degree term components of the first magnetic field are set to be substantially zero, that is, $b_{1M}$ 0, $b_{2M}$ 0,..., $b_{iM}$ 0. Furthermore, the number of turns of the superconducting wire of the second superconducting coil assembly and the amount of the magnetic member of the yoke magnetic shield are set so that the sums of the terms of the same degrees of the higher-degree term components of the second and third magnetic fields are set to be substantially zero, that is, $-b_{1A} + b_{1Y}$ 0, $-b_{2A} + b_{2Y}$ 0,..., $-b_{iA} + b_{iY}$ 0. In this case, the intensity of the synthesized magnetic field is defined by only the degree-0 term components, and the synthesized magnetic field is set at a high homogeneity.

Furthermore, the means for setting the higher-degree term components of the synthesized magnetic fields to be substantially zero may be arranged as follows.

The number of turns of the superconducting wire of the second superconducting coil assembly is set, so that the terms of the higher-degree term components of the second magnetic field are set to be substantially zero, that is, $b_{1A}$ 0, $b_{2A}$ 0,..., $b_{iA}$ 0. Furthermore, the number of turns of the superconducting wire of the first superconducting coil assembly and the amount of the magnetic member of the yoke magnetic shield are set so that the sums of the terms of the same degrees of the higher-degree term components of the first and third magnetic fields are set to be substantially zero, that is, $b_{1M} + b_{1Y}$ 0, $-b_{2M} + b_{2Y}$ 0,..., $b_{iM} + b_{iY}$ 0. In this case, the intensity of the synthesized magnetic field is defined by only the degree-0 term components, and the synthesized magnetic field is set at a high homogeneity.

As described above, the magnetic fringe field is reduced by a cooperation of the active and yoke magnetic shields, and the synthesized magnetic field in the working volume 18 is set at a high homogeneity. For this reason, the volumes of the active and yoke magnetic shields can be reduced to be smaller than those of the conventional ones.

Since the volume of the active magnetic shield can be reduced, the outer dimensions of the magnet apparatus can be reduced. For this reason, the MRI system can be rendered compact, and can be easily carried and installed in a hospital or the like. Since the volume of the active magnetic shield can be reduced, the amount of use of a superconducting wire can be reduced. Thus, an increase in manufacturing cost of the magnet apparatus can be suppressed.

Since the volume of the yoke magnetic shield can be reduced, the weight of the yoke magnetic shield can be decreased. As a result, the MRI system can be easily carried and installed in a hospital or the like. In addition, the floor structure in the hospital need not be specially reinforced for installation of the MRI system in the hospital.

The magnetic fringe field is absorbed by the yoke magnetic shield. For this reason, leaking magnetic fluxes reaching ferromagnetic members such as reinforcements arranged in columns and floors can be eliminated. For this reason, a leaking magnetic field whose magnetic flux density is changed by these magnetic members enters the working volume less often. Therefore, the homogeneity of the magnetic field in the working volume can be prevented from being deteriorated by the influence of the ferromagnetic members such as reinforcements arranged in columns and floors.

Furthermore, the length, along the Z axis, of the shell member 20 of the yoke magnetic shield is smaller than that of the second superconducting coil. For this reason, disturbance of magnetic fluxes at the end portions of the magnet apparatus 6 in the Z direction can be eliminated. For this reason, the homogeneity of the magnetic field in the working volume 18 can be improved.

The yoke magnetic shield 19 is divided into four pieces and these pieces are carried in a hospital or the like. The pieces are assembled in the hospital. Thus, carry-in and installation of the MRI system in the hospital can be further facilitated. Note that after assembly, the legs 33 of the magnet apparatus and the legs 34 of the yoke magnetic shield 19 are coupled through the coupling plates 35.

An embodiment of the present invention will be described below with reference to Fig. 4. In this embodiment, a plurality of iron shims 36 are attached to the inner peripheral surface of the warm bore 7. The iron shims 36 serve to finely adjust the shape of lines of magnetic forces in the bore 7, thus improving homogeneity of the magnetic field in the working volume 18.

The iron shims 36 electromagnetically form a fourth magnetic field in the working volume 18. More specifically, some of the magnetic fluxes of the first to third magnetic fields are magnetically changed by the iron shims 36, thus forming the fourth magnetic field in the working volume 18. For this reason, the first to fourth magnetic fields are present in the working volume 18, and form a synthesized magnetic field.

In this case, a means for setting the synthesized magnetic field at a high uniformity level is arranged as follows.

The intensity of the fourth magnetic field is expressed by a degree-0 term component and higher-degree term components (i.e., error components), and is series-developed as follows:

$$
\begin{aligned}
B_S &= B_{0S} + \sum_{i=1}^{\infty} b_{iS} \\
&= B_{0S} + b_{1S} + b_{2S} + \cdots + b_{iS} + \cdots
\end{aligned}
$$

$$\cdots (5)$$

$B_S$: first magnetic field intensity

$B_{0S}$: degree-0 term component

$\sum_{i=1}^{\infty}{}^{]} b_{iS}$: higher-degree term components

$b_{iS}$: term of degree $i$ of the higher-degree term components

Therefore, from equations (1) to (3) and equation (5), the intensity of the synthesized magnetic field is expressed as follows:

$$B_M - B_A + B_Y + B_S = B_{0M} - B_{0A} + B_{0Y} + B_{0S}$$
$$+ \sum_{i=1}^{\infty} (b_{iM} - b_{iA} + b_{iY} + b_{iS})$$
$$\dots (6)$$

If the higher-degree term components (i.e., error components)

$$\sum_{i=1}^{\infty}$$

$(b_{iM} - b_{iA} + b_{iY} + b_{iS})$ are set to be substantially zero, the intensity of the synthesized magnetic field consists of only the degree-0 term components. Thus, the synthesized magnetic field is set at a high homogeneity.

For this purpose, in the embodiment, the numbers of turns of the superconducting wires of the first and second superconducting coil assemblies and the amounts of the magnetic members of the yoke magnetic shield and the iron shims are determined so that the sums of the terms of the same degrees of the higher-degree term components of the first to fourth magnetic fields is set to be substantially zero, that is, $b_{1M} - b_{1A} + b_{1Y} + b_{1S}$ 0,..., $b_{iM} - b_{iA} + b_{iY} + b_{iS}$ 0. As a result, the intensity of the synthesized magnetic field is defined by only the degree-0 term components $B_{0M} - B_{0A} + B_{0Y} + B_{0S}$, and the synthesized magnetic field is set at a high homogeneity.

The means for setting the higher-degree term components of the synthesized magnetic fields to be substantially zero may be arranged as follows.

The number of turns of the superconducting wire of the first superconducting coil assembly is set, so that the terms of the higher-degree term components of the first magnetic field are set to be substantially zero, that is, $b_{1M}$ 0,..., $b_{iM}$ 0. Furthermore, the number of turns of the superconducting wire of the second superconducting coil assembly and the amounts of the magnetic members of the yoke magnetic shield and the iron shims are set so that the sums of the terms of the same degrees of the higher-degree term components of the second and fourth magnetic fields are set to be substantially zero, that is, $-b_{1A} + b_{1Y} + b_{1S}$ 0,..., $b_{iA} + b_{iY} + b_{iS}$ 0. In this case, the intensity of the synthesized magnetic field is defined by only the degree-0 term components, and the synthesized magnetic field is set at a high homogeneity.

Furthermore, the means for setting the higher-degree term components of the synthesized magnetic fields to be substantially zero may be arranged as follows.

The number of turns of the superconducting wire of the second superconducting coil assembly is set, so that the terms of the higher-degree term components of the second magnetic field are set to be substantially zero, that is, $-b_{1A}$ 0,..., $-b_{iA}$ 0. Furthermore, the number of turns of the superconducting wire of the first superconducting coil assembly and the amounts of the magnetic members of the yoke magnetic shield and the iron shims are set so that the sums of the terms of the same degrees of the higher-degree term components of the first, third, and fourth magnetic fields are set to be substantially zero, that is, $b_{1M} + b_{1Y} + b_{1S}$ 0,..., $b_{iM} + b_{iY} + b_{iS}$ 0. In this case, the intensity of the synthesized magnetic field is defined by only the degree-0 term components, and the synthesized magnetic field is set at a high homogeneity.

Therefore, in the above embodiment, the synthesized magnetic field in the working volume can be set at a high homogeneity, and a magnetic fringe field can be reduced.

## Claims

1.   A magnet apparatus for use in a magnetic resonance imaging system, said system having a bore (7) housing an object to be examined, and a working volume (18) where a portion to be diagnosed of the object to be examined is located being defined in the bore, said magnetic apparatus (6) comprising:

a first superconducting coil assembly (26), arranged radially outside the bore (7), for generating a first magnetic field in the working volume (18);

an active magnetic shield (27) including a second superconducting coil assembly, arranged radially outside the bore (7) and electrically connected in series with said first superconducting coil assembly (26), for generating a second magnetic field in a direction opposite to the direction of the first magnetic field in the working volume (18); a vacuum container (32) maintaining said first and second superconducting coil assemblies (26, 27) in a cryogenic state and

a yoke magnetic shield (19), arranged radially outside said first superconducting coil assembly (26) and said active magnetic shield (27) and formed of a ferromagnetic member, wherein:

most of magnetic fluxes of the first and second magnetic fields leaking outside the bore (7) cancel each other to be weakened and are absorbed in said yoke magnetic shield (19) so as to reduce an amount of leaking magnetic fluxes,

some of the magnetic fluxes of the first and second magnetic field field leaking outside the bore (7) are magnetically changed by said yoke magnetic shield (19) and enter the bore (7) to form a third magnetic field in the working volume (18),

the first to third magnetic fields are synthesized in the working volume (18) to form a synthesized magnetic field, and

a magnetic central axis (Z axis) of said first superconducting coil assembly (269 extends in the working volume (18) in a direction of the first magnetic field, a midplane (29) of said magnet apparatus (6) being perpendicular to the magnetic central axis, and said yoke magnetic shield (19) being arranged symmetrically with reference to the mid-plane (29),

characterized in that

said yoke magnetic shield (19) includes a cylindrical shell member (20) formed of a ferromagnetic material,

the length of said cylindrical shell member (20) along the magnetic central axis is smaller than that of said vacuum container (32),

the length of said cylindrical shell member (20) along the magnetic central axis is larger than that of said first superconducting coil assembly (26) and is smaller than that of said second superconducting coil assembly (27).

2. An apparatus according to claim 1, characterized in that
said first superconducting coil assembly (26) includes a plurality of coaxial coils arranged symmetrically with reference to the mid-plane (29).

3. An apparatus according to claim 1, characterized in that
said second superconducting coil assembly (27) includes a plurality of coaxial coils arranged symmetrically with reference to the mid-plane.

4. An apparatus according to claim 1, characterized in that
said yoke magnetic shield (19) includes members (21), attached to two end portions of said shell members (20) and formed of a ferromagnetic material, for absorbing magnetic fluxes of the first and second magnetic fields leaking outside the bore.

5. An apparatus according to claim 1, characterized in that
said cylindrical shell member (20) is divided into a plurality of segments.

6. An apparatus according to claim 5, characterized in that
said cylindrical shell member (20) is divided into two segments by the mid-plane (29).

7. An apparatus according to claim 5, characterized in that
said cylindrical shell member (20) is divided into two segments by a flat plane along the magnetic central axis.

8. An apparatus according to claim 5, characterized in that
said cylindrical shell member (20) is divided into four segments by flat planes respectively along the mid-plane (29) and the magnetic central axis.

**9.** An apparatus according to claim 1, characterized in that
said first and second superconducting coil assemblies (26, 27) and said yoke magnetic shield (19) are coaxially arranged about the magnetic central axis.


## Patentansprüche

**1.** Magnetgerät zur Verwendung in einem Magnetresonanz-Abbildungssystem, wobei das System eine Bohrung (7) hat, in der ein zu untersuchendes Objekt aufgenommen ist, und wobei ein Arbeitsvolumen (18), wo ein zu diagnostizierender Teil des zu untersuchenden Objektes gelegen ist, in der Bohrung definiert ist, wobei das Magnetgerät (6) aufweist:
eine erste supraleitende Spulenanordnung (26), die radial außerhalb der Bohrung (7) angeordnet ist, um ein erstes Magnetfeld in dem Arbeitsvolumen (18) zu erzeugen,
eine aktive magnetische Abschirmung (27) mit einer zweiten supraleitenden Spulenanordnung, angeordnet radial außerhalb der Bohrung (7) und elektrisch in Reihe mit der ersten supraleitenden Spulenanordnung (26) verbunden, um ein zweites Magnetfeld in einer Richtung entgegengesetzt zu der Richtung des ersten Magnetfeldes in dem Arbeitsvolumen zu erzeugen,
einen Vakuumbehälter (32), der die ersten und zweiten supraleitenden Spulenanordnungen (26, 27) in einem Kryogenzustand hält, und
eine Jochmagnetabschirmung (19), die radial außerhalb der ersten supraleitenden Spulenanordnung (26) und der aktiven Magnetabschirmung (27) angeordnet und aus einem ferromagnetischen Glied gebildet ist, wobei:
das meiste der Magnetflüsse der ersten und zweiten Magnetfelder, die nach außen von der Bohrung (7) austreten, einander aufheben, um geschwächt zu werden, und in der Jochmagnetabschirmung (19) absorbiert werden, um so eine Größe von Leckmagnetflüssen zu verringern,
einige der Magnetflüsse des ersten und zweiten Magnetfeldes, die aus der Bohrung (7) nach außen treten, magnetisch durch die Jochmagnetabschirmung (19) verändert werden und in die Bohrung (7) eintreten, um ein drittes Magnetfeld in dem Arbeitsvolumen (18) zu bilden,
die ersten bis dritten Magnetfelder in dem Arbeitsvolumen (18) zusammengesetzt werden, um ein zusammengesetztes Magnetfeld zu bilden, und
eine magnetische zentrale Achse (Z-Achse) der ersten supraleitenden.Spulenanordnung (26) sich in das Arbeitsvolumen (18) in einer Richtung des ersten Magnetfeldes erstreckt, wobei eine Mittelebene (29) des Magnetgerätes (6) senkrecht zu der magnetischen zentralen Achse ist und die Jochmagnetabschirmung (19) symmetrisch bezüglich der Mittelebene (29) angeordnet ist,
dadurch gekennzeichnet, daß
die Jochmagnetabschirmung (19) ein aus einem ferromagnetischem Material gebildetes zylindrisches Schalenglied (20) umfaßt,
die Länge des zylindrischen Schalengliedes (20) längs der magnetischen zentralen Achse kleiner ist als diejenige des Vakuumbehälters (32),
die Länge des zylindrischen Schalengliedes (20) längs der magnetischen zentralen Achse größer ist als diejenige der ersten supraleitenden Spulenanordnung (26) und kleiner ist als diejenige der zweiten supraleitenden Spulenanordnung (27).

**2.** Gerät nach Anspruch 1, dadurch gekennzeichnet, daß
die erste supraleitende Spulenanordnung (26) eine Vielzahl von koaxialen Spulen umfaßt, die symmetrisch bezüglich der Mittelebene (29) angeordnet sind.

**3.** Gerät nach Anspruch 1, dadurch gekennzeichnet, daß
die zweite supraleitende Spulenanordnung (27) eine Vielzahl von koaxialen Spulen umfaßt, die symmetrisch bezüglich der Mittelebene angeordnet sind.

**4.** Gerät nach Anspruch 1, dadurch gekennzeichnet, daß
die Jochmagnetabschirmung (19) Glieder (21) umfaßt, die an zwei Endteilen der Schalenglieder (20) angebracht und aus einem ferromagnetischen Material gebildet sind, um Magnetflüsse der nach außen von der Bohrung tretenden ersten und zweiten Magnetfelder zu absorbieren.

**5.** Gerät nach Anspruch 1, dadurch gekennzeichnet, daß
das zylindrische Schalenglied (20) in eine Vielzahl von Segmenten unterteilt ist.

**6.** Gerät nach Anspruch 5, dadurch gekennzeichnet, daß
das zylindrische Schalenglied (20) in zwei Segmente durch die Mittelebene (29) unterteilt ist.

**7.** Gerät nach Anspruch 5, dadurch gekennzeichnet, daß
das zylindrische Schalenglied (20) in zwei Segmente durch eine flache Ebene längs der magnetischen zentralen Achse unterteilt ist.

**8.** Gerät nach Anspruch 5, dadurch gekennzeichnet, daß
das zylindrische Schalenglied (20) in vier Segmente durch flache Ebenen jeweils längs der Mittelebene (29) und der magnetischen zentralen Achse unterteilt ist.

**9.** Gerät nach Anspruch 1, dadurch gekennzeichnet, daß die ersten und zweiten supraleitenden Spulenanordnungen (26, 27) und die Jochmagnetabschirmung (19) koaxial um die magnetische zentrale Achse angeordnet sind.

## Revendications

**1.** Un appareil magnétique à utiliser dans un système d'imagerie par résonance magnétique, ledit système comportant un alésage (7) renfermant un objet à examiner, et un volume de travail (18), dans lequel une partie de l'objet à examiner soumise à diagnostic est située, défini dans l'alésage, ledit appareil magnétique (6) comportant :
un premier ensemble à enroulement supraconducteur (26), disposé radialement à l'extérieur de l'alésage (7), pour engendrer un premier champ magnétique dans le volume de travail (18) ;
un écran magnétique actif (27) comportant un second ensemble à enroulement supraconducteur, disposé radialement à l'extérieur de l'alésage (7) et électriquement relié en série avec ledit premier ensemble à enroulement supraconducteur (26), pour engendrer un second champ magnétique dans une direction opposée à la direction du premier champ magnétique dans le volume de travail (18) ;
un récipient à vide (32) maintenant lesdits premier et second ensembles à enroulement supraconducteur (26, 27) dans un état cryogénique ; et
un écran magnétique (19) en culasse, disposé radialement à l'extérieur dudit premier ensemble à enroulement supraconducteur (26) et dudit écran magnétique actif (27) et formé d'un élément ferromagnétique, dans lequel:
la plupart des flux magnétiques des premier et second champs magnétiques fuyant à l'extérieur de l'alésage (7) s'annulent l'un l'autre pour être affaiblis et sont absorbés dans ledit écran magnétique (19) en culasse de manière à réduire la quantité des flux magnétiques de fuite,
certains des flux magnétiques des premier et second champs magnétiques fuyant à l'extérieur de l'alésage (7) sont magnétiquement modifiés par ledit écran magnétique (19) en culasse et pénètrent dans l'alésage (7) pour former un troisième champ magnétique dans le volume de travail (18),
les premier à troisième champs magnétiques sont synthétisés dans le volume de travail (18) pour former un champ magnétique synthétisé, et
l'axe central magnétique (axe Z) dudit premier ensemble à enroulement supraconducteur (26) s'étend dans le volume de travail (18) dans la direction du premier champ magnétique, le plan médian (29) dudit appareil magnétique (6) étant perpendiculaire à l'axe central magnétique, et ledit écran magnétique (19) en culasse étant disposé symétriquement en référence au plan médian (29),
caractérisé en ce que
ledit écran magnétique (19) en culasse comporte un élément en coquille cylindrique (20) formé d'une matière ferromagnétique,
la longueur dudit élément en coquille cylindrique (20) le long de l'axe central magnétique est inférieure à celle dudit récipient à vide (32),
la longueur dudit élément en coquille cylindrique (20) le long de l'axe central magnétique est supérieure à celle dudit premier ensemble à enroulement supraconducteur (26) et est inférieure à celle dudit second ensemble à enroulement supraconducteur (27).

**2.** Un appareil selon la revendication 1, caractérisé en ce que
ledit premier ensemble à enroulement supraconducteur (26) comporte une pluralité d'enroulements coaxiaux disposés symétriquement en référence au plan médian (29).

3. Un appareil selon la revendication 1, caractérisé en ce que
ledit second ensemble à enroulement supraconducteur (27) comporte une pluralité d'enroulements coaxiaux disposés symétriquement en référence au plan médian.

4. Un appareil selon la revendication 1, caractérisé en ce que
ledit écran magnétique (19) en culasse comporte des éléments (21) assujettis à deux parties extrêmes desdits éléments (20) en coquille et formés d'une matière ferromagnétique, pour absorber les flux magnétiques des premier et second champs magnétiques fuyant à l'extérieur de l'alésage.

5. Un appareil selon la revendication 1, caractérisé en ce que
ledit élément en coquille cylindrique (20) est divisé en une pluralité de segments.

6. Un appareil selon la revendication 5, caractérisé en ce que
ledit élément en coquille cylindrique (20) est divisé en deux segments par le plan médian (29).

7. Un appareil selon la revendication 5, caractérisé en ce que
ledit élément en coquille cylindrique (20) est divisé en deux segments par un plan le long de l'axe central magnétique.

8. Un appareil selon la revendication 5, caractérisé en ce que
ledit élément en coquille cylindrique (20) est divisé en quatre segments par des plans, respectivement le long du plan médian (29) et de l'axe central magnétique.

9. Un appareil selon la revendication 1, caractérisé en ce que
lesdits premier et second ensembles à enroulement supraconducteur (26, 27) et ledit écran magnétique (19) en culasse sont disposés coaxialement autour de l'axe central magnétique.

F I G. 1

F I G. 2

F I G. 3

13

F I G. 4